# EUROPEAN PATENT APPLICATION

(11) **EP 2 312 625 A2**
(43) Date of publication of application: **20.04.2011**
(21) Application number: 10186703.4
(22) Date of filing: 06.10.2010
(51) Int. Cl.: H01L 23/29, H01L 23/31, H01L 33/50, H01L 33/56

(54) **Optical-semiconductor encapsulating material**

(30) Priority: 07.10.2009 JP 2009233347
(71) Applicant: Nitto Denko Corporation, Ibaraki-shi Osaka 567-8680 (JP)
(72) Inventor: Fujioka, Kazuya, Osaka 567-8680 (JP); Matsuda, Hirokazu, Osaka 567-8680 (JP); Akazawa, Koji, Osaka 567-8680 (JP)
(74) Representative: Grünecker, Kinkeldey, Stockmair & Schwanhäusser Anwaltssozietät

(57) **Abstract**

The present invention relates to a sheet-shaped optical-semiconductor encapsulating material including: a first resin layer containing inorganic particles; and a second resin layer containing a phosphor and being superposed directly or indirectly on the first resin layer, and relates to a kit for optical-semiconductor encapsulation including: a sheet-shaped molded body including a first resin layer containing inorganic particles; and a sheet-shaped molded body including a second resin layer containing a phosphor.

## Description

### FIELD OF THE INVENTION

The present invention relates to an optical-semiconductor encapsulating material. More particularly, the invention relates to a package for encapsulating a light-emitting element such as a light-emitting diode or a semiconductor laser, and relates to a sheet-shaped optical-semiconductor encapsulating material for inhibiting an increase in temperature of an encapsulating resin at the time of lighting the light emitting element, an optical-semiconductor encapsulation kit including sheet-shaped molded bodies, and optical semiconductor devices obtained through encapsulation with the encapsulating material or the sheets.

### BACKGROUND OF THE INVENTION

Generally, methods for emitting white light using a blue LED include a method of coating an LED chip with a phosphor-containing resin, a method of potting a phosphor-containing resin to a cap-shaped LED device, and further, a method of laminating sheet-shaped phosphor-containing resin layers, followed by encapsulation.

For example, patent document 1 discloses a light emitting device in which a translucent resin is encapsulated around an LED chip and cured, followed by encapsulating the cured translucent resin with a fluorescent material-containing resin. In such a device, the fluorescent material can be almost uniformly distributed in an upper surface direction in which the emission intensity of the LED chip is strong, so that it becomes possible to prevent color heterogeneity of an emission color of the light emitting element, and to improve the efficiency of wavelength conversion due to the fluorescent material. Further, the use of the expensive fluorescent material is reduced, which makes it possible to realize the low-cost light emitting element.

Patent Document 1: JP-A-2000-156528

### SUMMARY OF THE INVENTION

However, in an optical semiconductor device having such a structure as described in patent document 1, emitted light is irradiated as such to the fluorescent material which lies directly on the LED chip, so that there is a problem that the temperature of the fluorescent material-containing resin portion (phosphor-containing resin) extremely increases by loss energy at the time of wavelength conversion, resulting in easy deterioration of the resin.

An object of the invention is to provide a sheet-shaped optical-semiconductor encapsulating material which includes an encapsulating-resin layer (translucent resin layer) for coating an LED chip and a resin layer containing a phosphor (phosphor-containing resin layer) in which the sheet-shaped optical-semiconductor encapsulating material is capable of inhibiting an increase in temperature of an encapsulating resin at the time of lighting-up of an LED, to provide a kit for optical-semiconductor encapsulation including sheet-shaped molded bodies of the respective resin layers, and to provide optical semiconductor devices obtained through encapsulation with the encapsulating material or the sheets.

The present inventors have made intensive studies in order to solve the above-mentioned problem. As a result, it has been found that in a sheet-shaped encapsulating material including a first resin layer of a translucent resin and a second resin layer of a phosphor-containing resin, an increase in temperature of the second resin layer can be inhibited by dispersing inorganic particles in the first resin layer, thus leading to the completion of the invention.

Namely, the present invention relates to the following items (1) to (11),
(1) A sheet-shaped optical-semiconductor encapsulating material including:
   a first resin layer containing inorganic particles; and
   a second resin layer containing a phosphor and being superposed directly or indirectly on the first resin layer.
(2) The sheet-shaped optical-semiconductor encapsulating material according to (1), in which a constituent resin of the first resin layer contains a silicone resin.
(3) The sheet-shaped optical-semiconductor encapsulating material according to (1) or (2), in which the inorganic particles contain at least one selected from the group consisting of silicon dioxide and barium sulfate.
(4) The sheet-shaped optical-semiconductor encapsulating material according to any one of (1) to (3), in which a constituent resin of the second resin layer contains a silicone resin.
(5) A kit for optical-semiconductor encapsulation including:
   a sheet-shaped molded body including a first resin layer containing inorganic particles; and
   a sheet-shaped molded body including a second resin layer containing a phosphor.
(6) The kit for optical-semiconductor encapsulation according to (5), in which a constituent resin of the first resin layer contains a silicone resin.
(7) The kit for optical-semiconductor encapsulation according to (5) or (6), in which the inorganic particles contain at least one selected from the group consisting of silicon dioxide and barium sulfate.
(8) The kit for optical-semiconductor encapsulation according to any one of (5) to (7), in which a constituent resin of the second resin layer contains a silicone resin.
(9) An optical semiconductor device produced by a method including:
   placing the sheet-shaped optical-semiconductor encapsulating material according to any one of (1) to (4) on or over a substrate having an optical semiconductor element mounted thereon, so that the first resin layer faces the optical semiconductor element; and
   press-molding the sheet-shaped optical-semiconductor encapsulating material to encapsulate the optical semiconductor element.
(10) An optical semiconductor device obtained through encapsulation with the kit for optical-semiconductor encapsulation according to any one of (5) to (8), in which the optical semiconductor device is produced by a method including:
   placing the sheet-shaped molded body including the first resin layer on or over a substrate having an optical semiconductor element mounted thereon;
   superposing the sheet-shaped molded body including the second resin layer on or over the sheet-shaped molded body including the first resin layer; and
   press-molding the sheet-shaped molded bodies to encapsulate the optical semiconductor element.
(11) An optical semiconductor device including:
   a substrate having an optical semiconductor element mounted thereon;
   a first resin layer containing inorganic particles; and
   a second resin layer containing a phosphor,
   in which the optical semiconductor element is encapsulated with the first resin layer and the second resin layer in this order.

The sheet-shaped optical-semiconductor encapsulating material of the invention is an encapsulating material including a first resin layer of a translucent resin and a second resin layer of a phosphor-containing resin, and exhibits an excellent effect that an increase in temperature of the second resin layer at the time of lighting-up of an LED can be inhibited. Furthermore, the sheet-shaped molded body including the first resin layer and the second resin layer superposed thereon directly or indirectly, can be easily used in en bloc encapsulation by superposing the molded body on an optical semiconductor device and press-molding the molded body.

### BRIEF DESCRIPTION OF THE DRAWING

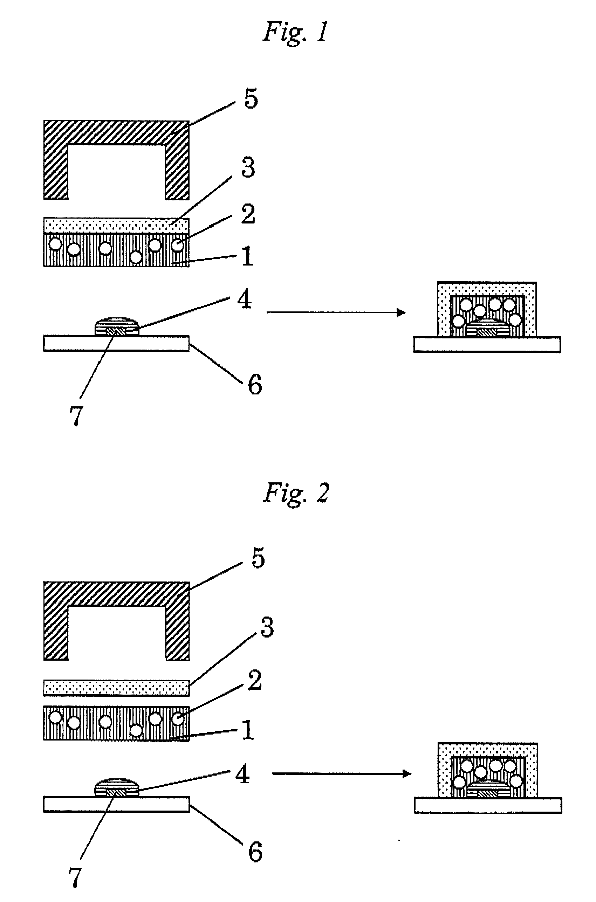

Fig. 1 is view illustrating encapsulation of an LED chip with a sheet-shaped optical-semiconductor encapsulating material of the invention, in which the left shows a state before encapsulation; and the right shows the encapsulated LED chip.
Fig. 2 is view illustrating encapsulation of an LED chip with a kit for optical-semiconductor encapsulation of the invention, in which the left shows a state before encapsulation; and the right shows the encapsulated LED chip.

### DETAILED DESCRIPTION OF THE INVENTION

The sheet-shaped optical-semiconductor encapsulating material of the invention (referred to also as "sheet of the invention") is a material in which the first resin layer and the second resin layer have been superposed directly or indirectly, and the first resin layer contains inorganic particles and the second resin layer contains a phosphor. Encapsulation of an optical semiconductor device with such a sheet-shaped encapsulating material is conducted, for example, by placing the sheet-shaped encapsulating material on a substrate having an optical semiconductor element mounted thereon, so that the first resin layer faces the LED chip (optical semiconductor element), and press-molding the encapsulating material. Accordingly, light emitted from the LED passes through the first resin layer, the wavelength thereof is converted by the phosphor in the second resin layer, followed by being radiated as such. Consequently, emitted light having high luminance is obtained. However, the emitted light which has passed thorough the first resin layer reaches the phosphor as such, and the wavelength thereof is converted there. Accordingly, loss energy of the phosphor at the time of wavelength conversion is absorbed by the second resin layer, resulting in an increase in temperature of the second resin layer. In the invention, therefore, the light reaching the second resin layer can be dispersed by a light scattering effect of the inorganic particles by incorporating the inorganic particles into the first resin layer, so that the heat generation density (heat generation amount per unit volume of the resin layer) due to the phosphor is decreased. As a result, it is considered that heat generation can be inhibited as a whole. Incidentally, in this specification, the term "sheet in which the layers have been superposed directly" means a sheet formed by directly superposing the second resin layer on the first resin layer, while the term "sheet in which the layers have been superposed indirectly" means a sheet formed by superposing the second resin layer over the first resin layer through any desired layer, for example, a known resin layer, e.g., an epoxy resin layer, by an ordinary method.

The first resin layer in the invention contains inorganic particles.

The inorganic particles are not particularly limited, as long as they can scatter visible light. However, the inorganic particles preferably include at least one selected from the group consisting of silicon dioxide and barium sulfate, and more particularly particles containing silicon dioxide, because of no decrease in luminance by encapsulation processing.

The average particle size of the inorganic particles may be any, as long as it can scatter visible light and is equal to or less than the thickness of the first resin layer. It is preferably from 0.1 to 200 µm, and more preferably from 0.3 to 40 µm. Further, it is still more preferably from 5 to 40 µm, from the viewpoint of inhibiting a decrease in temperature by encapsulation processing. Incidentally, in this specification, the average particle size of the inorganic particles can be measured by a method described in the example described later.

The shape of the inorganic particles may be any, as long as it can scatter visible light, and a spherical shape and a crushed shape are exemplified. However, a spherical shape is preferred from the viewpoint of inhibiting a decrease in luminance of the LED.

The content of the inorganic particles in the first resin layer is preferably from 0.1 to 70% by weight from the viewpoints of being uniformly dispersible in the first resin layer and inhibiting an increase in temperature of the second resin layer. Further, it is more preferably from 0.1 to 55% by weight from the viewpoint of inhibiting a decrease in luminance of the LED.

A constituent resin of the first resin layer is not particularly limited as long as it is a resin which has been conventionally used for optical semiconductor encapsulation. Examples thereof include translucent resins such as silicone resins, epoxy resins, styrene resins, acrylic resins, polycarbonate resins, urethane resins and polyolefin resin. These may be used either alone or as a combination of two or more thereof. Above all, silicone resins are preferred from the viewpoint of durability.

The second resin layer in the invention contains a phosphor.

The phosphor is not particularly limited, and examples thereof include known phosphors used in the optical semiconductor device. Specifically, a yellow phosphor (α-sialon), YAG, TAG and the like are exemplified as suitable commercially available phosphors having a function of converting a blue color to a yellow color.

The content of the phosphor is not sweepingly determined, because the degree of color mixture varies depending on the kind of phosphor and the thickness of the second resin layer.

A constituent resin of the second resin layer is not particularly limited as long as it is a resin which has been conventionally used for optical semiconductor encapsulation. The resins exemplified as the constituent resins of the second resin layer are similarly exemplified as those of the first encapsulating material. These may be used either alone or as a combination of two or more thereof. Above all, silicone resins are preferred from the viewpoint of durability.

In addition to the above-mentioned inorganic particles, phosphor and constituent resins, additives such as a curing agent, a curing accelerator, an aging inhibitor, a modifier, a surfactant, dyes, a pigment, a discoloration inhibitor and an UV absorber may be incorporated as raw material into the first resin layer and the second resin layer.

The sheet-shaped optical-semiconductor encapsulating material of the invention can be prepared by a method known to persons skilled in the art, so long as the first resin layer and the second resin layer have the compositions described above.

For example, each resin layer can be formed by adding inorganic particles, in the case of the first resin layer, or a phosphor, in the case of the second resin layer, to a constituent resin for each resin layer or to an organic-solvent solution of the resin, followed by mixing with stirring to prepare a solution for forming a resin layer; applying the solution, for example, onto a release sheet (for example, an polyethylene substrate) whose surface is release-treated, to an appropriate thickness by using an applicator or the like, and drying it by heating at such a temperature that the solvent is removable. The heating temperature cannot be sweepingly determined, because it varies depending on the kind of resin or solvent However, it is preferably from 80 to 150°C, and more preferably from 90 to 150°C. Incidentally, a sheet obtained by laminating a plurality of sheets and pressing them by hot pressing at 20 to 100°C to integrate them may be used as one resin layer.

The first resin layer and second resin layer obtained are press-bonded in the same manner as described above. Thus, a sheet-shaped optical-semiconductor encapsulating material can be obtained.

Alternatively, use may be made of a method in which either a first resin layer or a second resin layer is formed in the same manner as described above and a solution for forming the other resin layer is thereafter applied directly to that resin layer with an applicator or the like in an appropriate thickness and then heated and dried to thereby form a sheet-shaped optical-semiconductor encapsulating material of the invention.

Thus, the sheet-shaped optical-semiconductor encapsulating material including a first resin layer and a second resin layer superposed thereon is obtained. Incidentally, an sheet-shaped optical-semiconductor encapsulating material including any desired resin layer interposed between the first resin layer and the second resin layer may be obtained by forming such a resin layer beforehand in the same manner as described above; disposing this resin layer between the first resin layer and the second resin layer; and press-bonding the layers. Alternatively, use may be made of a method in which such a resin layer is formed on either the first resin layer or the second resin layer, and the remaining resin layer is thereafter formed on this resin layer.

The thickness of the first resin layer is preferably 100 to 1,000 µm, more preferably 300 to 800 µm, from the viewpoint of encapsulation properties for the optical semiconductor element, The thickness of the second resin layer is preferably 20 to 300 µm more preferably 30 to 200 µm, from the viewpoints of phosphor concentration and coating properties. The thickness of the sheet-shaped optical-semiconductor encapsulating material of the invention, which has been united, is preferably 120 to 1,300 µm, more preferably 330 to 1,000 µm.

The invention further provides a kit for optical-semiconductor encapsulation which includes a sheet-shaped molded body including the first resin layer (referred to also as a first sheet) and a sheet-shaped molded body including the second resin layer (referred to also as a second sheet), and in which the first resin layer and the second resin layer have not been superposed.

The first sheet is not particularly limited so long as it is a sheet-shaped molded body including the first resin layer included in the sheet of the invention. The first sheet can be produced in the same manner as for each resin layer included in the sheet of the invention. The same applies to the sheet-shaped molded body including the second resin layer.

The kit for optical-semiconductor encapsulation of the invention may include another sheet-shaped molded body including any desired resin layer, besides the first sheet and second sheet. This optional sheet-shaped molded body can be produced in the same manner as for the first sheet and second sheet.

The invention furthermore provides an optical semiconductor device obtained through encapsulation with the sheet-shaped optical-semiconductor encapsulating material of the invention or with the kit for optical-semiconductor encapsulation of the invention. Examples thereof include: an optical semiconductor device produced by a method including placing the sheet-shaped optical-semiconductor encapsulating material of the invention on or over a substrate having an optical semiconductor element mounted thereon, so that the first resin layer faces the optical semiconductor element, and press-molding the encapsulating material to encapsulate the optical semiconductor element; and an optical semiconductor device produced through encapsulation with the kit for optical-semiconductor encapsulation of the invention by a method including placing the sheet-shaped molded body including the first resin layer on or over a substrate having an optical semiconductor element mounted thereon, superposing the sheet-shaped molded body including the second resin layer on or over the sheet-shaped molded body including the first resin layer, and press-molding the sheet-shaped molded bodies to encapsulate the optical semiconductor element.

The optical semiconductor device of the invention is not particularly limited so long as the device has been produced using the sheet-shaped optical-semiconductor encapsulating material of the invention or using the kit for optical-semiconductor encapsulation of the invention. The optical semiconductor device can be produced by a method known to persons skilled in the art.

For example, in the case where the sheet-shaped optical-semiconductor encapsulating material of the invention is used, this encapsulating material is placed on a substrate having an optical semiconductor element mounted thereon, so that the first resin layer faces the optical semiconductor element. The encapsulating material is then press-molded to thereby obtain an optical semiconductor device.

Additionally, for example, in the case where the kit for optical-semiconductor encapsulation of the invention is used, an optical semiconductor device is obtained by placing the sheet-shaped molded body including a first resin layer on a substrate having an optical semiconductor element mounted thereon, further superposing the sheet-shaped molded body including a second resin layer, and then en bloc press-molding the sheet-shaped molded bodies.

From the standpoint of adhesion to the substrate, a liquid encapsulating material including a translucent resin (referred to also as third encapsulating material) may be applied for potting before the sheet-shaped optical-semiconductor encapsulating material of the invention or the first sheet of the kit of the invention is superposed on the substrate having an optical semiconductor element mounted thereon, so long as the second resin layer is disposed more apart from the LED chip than the first resin layer from the standpoint of improving luminance. Although the resin constituting the third encapsulating material is not particularly limited, it is preferred that the resin should be the same as the constituent resin of the first resin layer.

The press-molding can be conducted by a method known to persons skilled in the art. For example, the press-molding can be accomplished by placing a mold on the encapsulating material and then heating the encapsulating material preferably at 100 to 160°C for 1 to 10 minutes while applying thereto a pressure of preferably 0.1 to 0.5 MPa, more preferably 0.1 to 0.3 MPa. After the press-molding, the resultant structure is allowed to stand until the shape becomes invariable even under room temperature. The mold is then removed, and the encapsulating material can be post-cured. The post cure can be performed, for example, by standing preferably for 15 minutes to 6 hours using a dryer preferably having a temperature of 100 to 150°C.

The optical semiconductor device of the invention includes the sheet-shaped optical-semiconductor encapsulating material of the invention or the kit for optical-semiconductor encapsulation of the invention. Accordingly, even in the optical semiconductor device equipped with a high-intensity LED element such as a blue element, a green LED element or the like, an increase in temperature of the encapsulating material is inhibited to inhibit deterioration thereof, while taking out the light emitting luminance in a high state. It can therefore be suitably used.

### EXAMPLES

The invention will be described below with reference to examples, comparative example and reference example. However, the invention is not construed as being limited by these examples.

### [Average Particle Size of Inorganic Particles]

In this specification, the average particle size of inorganic particles means the average particle size of primary particles and means 50% volume cumulative diameter (D₅₀) measured by a dynamic light scattering method for a particle-dispersed solution of the inorganic particles and calculated.

### EXAMPLE

### <First Resin Layer>

To 9.95 g of a silicone elastomer (ELASTOSIL LR-7665, manufactured by Wacker Asahikasei Silicone Co., Ltd.) was added 0.05 g of silicon dioxide (FB-7SDC, manufactured by Denki Kagaku Kogyo K.K.; average particle size: 5.8 µm; spherical) (content of inorganic particles, 0.5% by weight). The silicon dioxide was uniformly dispersed by hand stirring to obtain a liquid silicon dioxide-containing resin,

### <Second Resin Layer>

To 8.4 g of a silicone elastomer (LR-7665) was added 1.6 g of YAG (content of phosphor: 16% by weight). The YAG was uniformly dispersed by hand stirring to obtain a liquid phosphor-containing resin.

### <Sheet for Optical-Semiconductor Encapsulation>

The phosphor-containing resin was applied with an applicator to a polycarbonate film in a thickness of 100 µm and dried at 90°C for 4 minutes and 30 seconds to obtain a phosphor-containing resin sheet. The silicon-dioxide-containing resin was likewise applied on the resultant phosphor-containing resin sheet in a thickness of 500 µm and dried at 125°C for 9 minutes to obtain a sheet for optical-semiconductor encapsulation.

### <Optical-Semiconductor Encapsulation>

A moderate amount of a silicone elastomer (LR-7665) was placed on a flat substrate on which an optical semiconductor element (wavelength region: 450 nm) was mounted, and the sheet for optical-semiconductor encapsulation was placed thereon so that the first resin layer faced the substrate. A mold having a diameter of 8 mm and a height of 500 µm was placed thereon, and pressed using a vacuum press apparatus (V-130 manufactured by Nichigo-Morton Co., Ltd.) for 5 minutes under conditions of 0.1 MPa and 160°C, thereby obtaining an optical semiconductor device.

### EXAMPLE 2

An optical semiconductor device was obtained in the same manner as in Example 1, except that the amounts of the silicone elastomer (LR-7665) and the silicon dioxide (FB-7SDC) in the first resin layer were changed to 9.5 g and 0.5 g, respectively (content of inorganic particles, 5% by weight).

### EXAMPLE 3

An optical semiconductor device was obtained in the same manner as in Example 1, except that the amounts of the silicone elastomer (LR-7665) and the silicon dioxide (FB-7SDC) in the first resin layer were changed to 7.0 g and 3.0 g, respectively (content of inorganic particles, 30% by weight).

### EXAMPLE 4

An optical semiconductor device was obtained in the same manner as in Example 1, except that the amounts of the silicone elastomer (LR-7665) and the silicon dioxide (FB-7SDC) in the first resin layer were changed to 5.0 g and 5.0 g, respectively (content of inorganic particles, 50% by weight).

### EXAMPLE 5

An optical semiconductor device was obtained in the same manner as in Example 1, except that the amounts of the silicone elastomer (LR-7665) and the silicon dioxide (FB-7SDC) in the first resin layer were changed to 3.0 g and 7.0 g, respectively (content of inorganic particles, 70% by weight).

### EXAMPLE 6

An optical semiconductor device was obtained in the same manner as in Example 3, except that the kind of silicon dioxide in the first resin layer was changed to silicon dioxide (FB-40S, manufactured by Denki Kagaku Kogyo K.K.; average particle size: 39.8 µm; spherical).

### EXAMPLE 7

An optical semiconductor device was obtained in the same manner as in Example 3, except that the kind of silicon dioxide in the first resin layer was changed to silicon dioxide (SFP-20M, manufactured by Denki Kagaku Kogyo K.K.; average particle size: 0.3 µm; spherical).

### EXAMPLE 8

An optical semiconductor device was obtained in the same manner as in Example 3, except that the kind of silicon dioxide in the first resin layer was changed to silicon dioxide (Crystalite 5X, manufactured by Tatsumori Ltd.; average particle size: 1.5 µm; crushed shape).

### EXAMPLE 9

An optical semiconductor device was obtained in the same manner as in Example 2, except that the kind of inorganic particles in the first resin layer was changed to barium sulfate (W-6, manufactured by Takehara Kagaku Kogyo Co., Ltd.; average particle size: 5.0 µm; crushed shape).

### EXAMPLE 10

An optical semiconductor device was obtained in the same manner as in Example 4, except that the kind of silicon dioxide in the first resin layer was changed to silicon dioxide (FB-40S).

### COMPARATIVE EXAMPLE 1

An optical semiconductor device was obtained in the same manner as in Example 1, except that no inorganic particles were added to the first resin layer.

### REFERENCE EXAMPLE 1

An optical semiconductor device was obtained in the same manner as in Example 2, except that the kind of inorganic particles in the first resin layer was changed to alumina (AS-50).

The optical semiconductor devices obtained were evaluated for properties according to the following Test Examples 1 and 2. The results thereof are shown in Table 1.

### TEST EXAMPLE 1 (Temperature of Second Resin Layer)

A moderate amount of heat radiation silicone (SCH-30 manufactured by Sunhayato Corp., thermal conductivity: 0.96 W/mK) was dropped onto a heat sink (material: copper), and the optical semiconductor device was fixed thereon. The current value was increased at 100 mA/sec until 10 seconds from the start of lighting, and after 3 minutes from reaching 500 mA, the maximum temperature of the second resin layer was measured. Incidentally, temperature measurement was performed by using a thermograph (CPA1000 manufactured by Chino Corp.) and focusing from above of the optical semiconductor device on lighting. Further, the lower resin temperature is preferred.

### TEST EXAMPLE 2 (Luminance)

Each optical semiconductor device was lighted at 50 mA, and the light emitting luminance at that time was measured according to hemispherical luminance measurement. Incidentally, an integrating sphere was used for luminance measurement, and the measurement was performed by using a multiple photometric system (MCPD-3000 manufactured by Otsuka Electronics Co., Ltd.). Further, the light emitting luminance (Y value) is more preferably 2,000 or more.

**Table 1**

| | Inorganic particles of first resin layer | | | | Properties | |
|---|---|---|---|---|---|---|
| | Kind | Average particle size (µm) | Shape | Content (wt%) | Temperature of second resin layer (°C) | Light Emitting Luminance (Y value) |
| Example 1 | Silicon dioxide | 5.8 | Spherical | 0.5 | 188 | 2342 |
| Example 2 | Silicon dioxide | 5.8 | Spherical | 5 | 175 | 2399 |
| Example 3 | Silicon dioxide | 5.8 | Spherical | 30 | 173 | 2320 |
| Example 4 | Silicon dioxide | 5.8 | Spherical | 50 | 165 | 2021 |
| Example 5 | Silicon dioxide | 5.8 | Spherical | 70 | 105 | 1921 |
| Example 6 | Silicon dioxide | 39.8 | Spherical | 30 | 159 | 2340 |
| Example 7 | Silicon dioxide | 0.3 | Spherical | 30 | 110 | 2011 |
| Example 8 | Silicon dioxide | 1.5 | Crushed | 30 | 95 | 1693 |
| Example 9 | Barium sulfate | 5.0 | Crushed | 5 | 165 | 1899 |
| Example 10 | Silicon dioxide | 39.8 | Spherical | 50 | 125 | 2100 |
| Comparative Example 1 | - | - | - | - | 200 | 2088 |
| Reference Example 1 | Alumina | 9 | Spherical | 5 | 230 | 1744 |

It can be seen from Table 1 that the optical semiconductor devices containing silicon dioxide or barium sulfate are inhibited from increasing in the temperature of the second resin layer.

While the invention has been described in detail with reference to specific embodiments thereof, it will be apparent to one skilled in the art that various changes and modifications can be made therein without departing from the spirit and scope thereof.
Incidentally, the present application is based on Japanese Patent Application No. 2009-233347 filed on October 7, 2009, and the contents are incorporated herein by reference,
All references cited herein are incorporated by reference herein in their entirety.

### INDUSTRLAL APPLICABILITY

The sheet-shaped optical-semiconductor encapsulating material of the invention is suitable for use in producing semiconductor devices for, for example, the backlights of liquid-crystal panels, traffic signals, large outdoor displays, advertising signboards, and the like.

### Description of Reference Numerals

- 1: First resin layer
- 2: Inorganic particle
- 3: Second resin layer containing phosphor
- 4: Third encapsulating material
- 5: Mold
- 6: Substrate
- 7: LED chip

## Claims

1. A sheet-shaped optical-semiconductor encapsulating material comprising:
a first resin layer containing inorganic particles; and
a second resin layer containing a phosphor and being superposed directly or indirectly on the first resin layer.

2. The sheet-shaped optical-semiconductor encapsulating material according to claim 1, wherein a constituent resin of the first resin layer contains a silicone resin.

3. The sheet-shaped optical-semiconductor encapsulating material according to claim 1 or 2, wherein the inorganic particles contain at least one selected from the group consisting of silicon dioxide and barium sulfate.

4. The sheet-shaped optical-semiconductor encapsulating material according to any one of claims 1 to 3, wherein a constituent resin of the second resin layer contains a silicone resin.

5. A kit for optical-semiconductor encapsulation comprising:
a sheet-shaped molded body comprising a first resin layer containing inorganic particles; and
a sheet-shaped molded body comprising a second resin layer containing a phosphor.

6. The kit for optical-semiconductor encapsulation according to claim 5, wherein a constituent resin of the first resin layer contains a silicone resin.

7. The kit for optical-semiconductor encapsulation according to claim 5 or 6, wherein the inorganic particles contain at least one selected from the group consisting of silicon dioxide and barium sulfate.

8. The kit for optical-semiconductor encapsulation according to any one of claims 5 to 7, wherein a constituent resin of the second resin layer contains a silicone resin.

9. An optical semiconductor device produced by a method comprising:
placing the sheet-shaped optical-semiconductor encapsulating material according to any one of claims 1 to 4 on or over a substrate having an optical semiconductor element mounted thereon, so that the first resin layer faces the optical semiconductor element; and
press-molding the sheet-shaped optical-semiconductor encapsulating material to encapsulate the optical semiconductor element.

10. An optical semiconductor device obtained through encapsulation with the kit for optical-semiconductor encapsulation according to any one of claims 5 to 8, wherein the optical semiconductor device is produced by a method comprising:
placing the sheet-shaped molded body comprising the first resin layer on or over a substrate having an optical semiconductor element mounted thereon;
superposing the sheet-shaped molded body comprising the second resin layer on or over the sheet-shaped molded body comprising the first resin layer; and
press-molding the sheet-shaped molded bodies to encapsulate the optical semiconductor element.

11. An optical semiconductor device comprising:
a substrate having an optical semiconductor element mounted thereon;
a first resin layer containing inorganic particles; and
a second resin layer containing a phosphor,
wherein the optical semiconductor element is encapsulated with the first resin layer and the second resin layer in this order.
